(19) Europäisches Patentamt / European Patent Office / Office européen des brevets

(11) **EP 4 418 103 B1**

(12) **EUROPEAN PATENT SPECIFICATION**

(45) Date of publication and mention
of the grant of the patent:
**17.09.2025   Bulletin 2025/38**

(21) Application number: **24157311.2**

(22) Date of filing: **13.02.2024**

(51) International Patent Classification (IPC):
**G06F 7/483** (2006.01)      **G06F 7/499** (2006.01)

(52) Cooperative Patent Classification (CPC):
**G06F 7/49947; G06F 7/4836**

(54) **HARDWARE EFFICIENT ROUNDING**

HARDWAREEFFIZIENTE RUNDUNG

ARRONDISSEMENT EFFICACE DU MATÉRIEL

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **17.02.2023   GB 202302254**

(43) Date of publication of application:
**21.08.2024   Bulletin 2024/34**

(73) Proprietor: **Imagination Technologies Limited
Kings Langley, Hertfordshire WD4 8LZ (GB)**

(72) Inventors:
• **King, Rostam
Kings Langley (GB)**
• **Fenney, Simon
St Albans (GB)**

(74) Representative: **Leaves, Paul
Imagination Technologies Ltd
Imagination House
Home Park Estate
Kings Langley, Herts WD4 8LZ (GB)**

(56) References cited:
US-A- 5 696 710      US-A1- 2014 280 405
US-A1- 2022 334 799

**Description**

CROSS-REFERENCE TO RELATED APPLICATION

This application claims priority from UK patent application GB2302254.4 filed on 17th February 2023.

TECHNICAL FIELD

The invention relates to rounding an unsigned normalised number, such as a UNORM.

BACKGROUND

Binary data for use by a processing unit typically comprises a number of bits. Data values can be represented by bits according to a number of different formats. For example, data values may be normalized data values which represent a number within a particular range. For example, a number may be represented using an n-bit UNORM value which is an unsigned normalized integer representing $2^n$ evenly spaced values between and including 0 and 1. For example, 0 is represented by an n-bit UNORM value with all n bits being zero, and 1 is represented by an n-bit UNORM value with all n bits being one.

As described above, an n-bit UNORM value is stored as an unsigned n-bit integer, x, and is interpreted as representing a rational number, X as given by:

$$X = \frac{x}{2^n - 1}$$

Note that in the nomenclature used herein, a capital letter refers to the equivalent rational value and a lower-case letter refers to the stored unsigned integer value. Since the stored UNORM value, x, is an integer, only particular numbers within the range from 0 to 1 can be represented. For example, for a 2-bit UNORM value, the bits '00' represent 0, the bits '01' represent 1/3, the bits '10' represent 2/3 and the bits '11' represent 1. It can be appreciated, for example, that there is no n-bit UNORM value which exactly represents 1/2. Furthermore, it can be shown that there is no n-bit UNORM value which represents a value exactly halfway between the values represented by two consecutive m-bit UNORM values.

A normalized n-bit value may be converted into a normalized m-bit value, where n#m. A conversion such as this may be used by a processing unit acting on the data for one of many different reasons as would be apparent to a person skilled in the art.

An m-bit UNORM value is stored as an unsigned m-bit integer, y, $y \in [0, 2^m - 1]$, and interpreted as representing a rational number, Y, given by:

$$Y = \frac{y}{2^m - 1}$$

Therefore, the m-bit UNORM value, y, which corresponds to the n-bit UNORM value, x, would be related as:

$\frac{y}{2^m - 1} \approx \frac{x}{2^n - 1}$ and thus

$$y \approx \frac{2^m - 1}{2^n - 1} x \qquad\qquad (1)$$

However, according to the UNORM data format, the m-bit UNORM value, y, must be an integer, so equation (1) uses rounding in order to find an integer value for y. Different rounding techniques may be used, such as round towards zero (RTZ), round towards positive infinity (RTP), and round towards the nearest integer. For example, one industry specification uses $y = \left\lfloor \frac{2^m - 1}{2^n - 1} x + \frac{1}{2} \right\rfloor$.

One way to calculate the value of y in accordance with equation (1) is to perform a multiplication operation to multiply x by $(2^m-1)$, a division operation to divide the result by $(2^n-1)$, and an addition operation to add a constant for the purposes of rounding. These multiplication and division operations tend to give a reliable result for the value of y, but in a hardware implementation in digital logic there may be a cost in terms of the silicon area and processing power, as well as the time taken to compute y by implementing these operations.

US 2014/280405 A1, US 2022/334799 A1, and US 5696710 A are further prior art.

SUMMARY

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

A binary logic circuit and method are disclosed for rounding an unsigned normalised n-bit binary number to an m-bit binary number. A correction value of length of n bits and a pre-truncation value of length of n bits are determined. The correction value is determined by shifting the n-bit number by m bits. The pre-truncation value is determined based on at least the n-bit number, the correction value, a value for the most significant bit (MSB) of the n-bit number, and a rounding value having a '1' at the $n$-$m^{th}$ bit position and a '0' at all other bits. The rounded m-bit number is then obtained by truncating the n-m least significant bits (LSB) of the pre-truncation value.

According to a first aspect there is provided a method of rounding an unsigned normalised n-bit number to an m-bit number, according to claim 1.

Optionally, the n-bit number may be a UNORM integer and/or n>m. The rounding value may be determined by shifting a value of '1' to the left by n-m-1 bits thereby positioning a 1 bit at the $n$-$m^{th}$ bit position. The value for the MSB of the n-bit number may be identified by shifting the number to the right by n-1 bits.

Optionally, determining a pre-truncation value comprises: subtracting the correction value from the n-bit number; subtracting an inverted version of the value for the MSB from the rounding value; and adding the output from the two subtractions to generate the pre-truncation value. The inverted version of the value for the MSB may be obtained by performing a NOT operation on the LSB of the value for the MSB.

Optionally, determining a pre-truncation value comprises: inverting the correction value; and adding the inverted correction value, rounding value and the value for the MSB of the n-bit number to the n-bit number to generate the pre-truncation value. Inverting the correction value may comprise performing a NOT operation on the bits of the correction value.

According to a second aspect there is provided a binary logic circuit for rounding an unsigned normalised n-bit number to an m-bit number, according to claim 8.

The binary logic circuit may further comprise rounding value logic configured to determine the rounding value by shifting value of '1' to the left by n-m-1 bits thereby positioning a '1' bit at the $n$-$m^{th}$ bit position. The MSB value logic may identify the value for the MSB of the number by shifting the number to the right by n-1 bits.

Optionally, the pre-truncation value logic comprises: a first subtractor for subtracting the correction value from the n-bit number; a second subtractor for subtracting an inverted version of the value for the MSB from the rounding value; and an adder for adding the output from the first subtractor and the second subtractor to generate the pre-truncation value. The inverted version of the value for the MSB may be obtained by performing a NOT operation on the LSB of the value for the MSB.

Optionally, the pre-truncation value logic comprises a plurality of adders configured to add an inverted version of the correction value, the rounding value and the value for the MSB to the received n-bit number to generate the pre-truncation value. The correction value logic may further comprise NOT logic configured to generate the inverted correction value.

According to a third aspect there is provided an image compression circuit comprising the binary logic circuit for rounding an n-bit number to an m-bit number, according to claim 12.

The binary logic circuit may be embodied in hardware on an integrated circuit. There may be provided a method of manufacturing, at an integrated circuit manufacturing system, the binary logic circuit. There may be provided an integrated circuit definition dataset that, when processed in an integrated circuit manufacturing system, configures the system to manufacture the binary logic circuit. There may be provided a non-transitory computer readable storage medium having stored thereon a computer readable description of the binary logic circuit that, when processed in an integrated circuit manufacturing system, causes the integrated circuit manufacturing system to manufacture an integrated circuit embodying the binary logic circuit.

There may be provided an integrated circuit manufacturing system comprising: a non-transitory computer readable storage medium having stored thereon a computer readable description of the binary logic circuit; a layout processing system configured to process the computer readable description so as to generate a circuit layout description of an integrated circuit embodying the binary logic circuit; and an integrated circuit generation system configured to manufacture the binary logic circuit according to the circuit layout description.

There may be provided computer program code for performing any of the methods described herein. There may be provided non-transitory computer readable storage medium having stored thereon computer readable instructions that, when executed at a computer system, cause the computer system to perform any of the methods described herein.

The above features may be combined as appropriate, as would be apparent to a skilled person, and may be combined with any of the aspects of the examples described herein.

BRIEF DESCRIPTION OF THE DRAWINGS

Examples will now be described in detail with reference to the accompanying drawings in which:

FIG. 1 is an illustration of numbers which can be represented by n-bit UNORM data values for values of n from 1 to 4;

FIG. 2 illustrates rounding and expanding an unsigned integer using methods of truncation and bit replication;

FIG. 3 illustrates a binary logic circuit 300 for rounding an n-bit number to an m-bit number;

FIG. 4 illustrates a flow diagram of a method of rounding an n-bit number to an m-bit number;

FIG. 5 illustrates a first embodiment of the binary logic circuit 300;

FIG. 6 illustrates a second embodiment of the binary logic circuit 300;

FIG. 7A illustrates an example of generating the correction value, rounding value and MSB value;

FIG. 7B illustrates an example of rounding the n-bit number using the binary logic circuit 500;

FIG. 7C illustrates an example of rounding the n-bit number using the binary logic circuit 600;

FIG. 8 shows a computer system in which a graphics processing system is implemented; and

FIG. 9 shows an integrated circuit manufacturing system for generating an integrated circuit embodying a graphics processing system.

The accompanying drawings illustrate various examples. The skilled person will appreciate that the illustrated element boundaries (e.g., boxes, groups of boxes, or other shapes) in the drawings represent one example of the boundaries. It may be that in some examples, one element may be designed as multiple elements or that multiple elements may be designed as one element. Common reference numerals are used throughout the figures, where appropriate, to indicate similar features.

DETAILED DESCRIPTION

The following description is presented by way of example to enable a person skilled in the art to make and use the invention. The present invention is not limited to the embodiments described herein and various modifications to the disclosed embodiments will be apparent to those skilled in the art.
Embodiments will now be described by way of example only.
As described above, an n-bit UNORM value is an unsigned n-bit integer, x, interpreted as representing a rational number X, given by:

$$X = \frac{x}{2^n - 1}$$

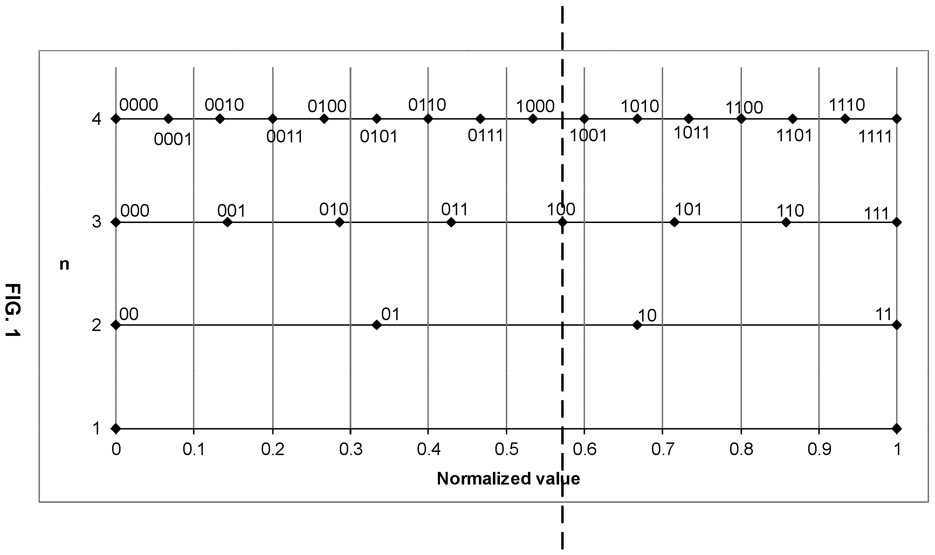

FIG. 1 is an illustration of numbers which can be represented by n-bit UNORM data values for values of n from 1 to 4. It is for clarity that Figure 1 does not show the numbers which can be represented by UNORM data values for values of n greater than 4. It can be seen in Figure 1 that an n-bit UNORM value represents one of a sequence of $2^n$ evenly spaced values between and including 0 and 1, with 0 being represented by an n-bit UNORM value with all n bits being zero, and 1 being represented by an n-bit UNORM value with all n bits being one.
As described above, an m-bit UNORM value, y, which corresponds to an n-bit UNORM value, x, is given by equation (1). The technique based on equation (1) works regardless of whether the number of bits are being decreased or increased by the conversion, e.g. whether n>m or n<m. Since according to the UNORM data format, the m-bit UNORM value, y, must be an integer, equation (1) may require some rounding in order to find an integer value for y. As a simple example, with reference to Figure 1, where n=3 and m=2, an n-bit UNORM value of x having the binary value '100' (representing the decimal integer numerator 4 in X=4/7, where $2^n$-1=7) corresponds to an m-bit UNORM value of y between the binary values '01' and '10' (representing the decimal integer numerators 1 and 2 in Y=1/3 and Y=2/3 respectively, where $2^m$-1=3). This is illustrated by the dashed arrow in Figure 1. However, because an m-bit UNORM value y can only represent values given by each integer between 0 to $2^m-1$ divided by $2^m-1$ (e.g. the 2-bit UNORM number in this example can represent the values of 0, 1/3, 2/3 and 1), the value of y which is chosen (noting that y must be an integer) will be determined by the rounding mode which is used.

For example, the conversion of a n-bit UNORM value, x, to a rounded m-bit UNORM value, y, where n > m may be performed as shown in equation (2) below. This rounds the result of the multiplication and division operations by adding a constant 0.5 value and applying the floor function. This implements a RTU rounding scheme.

$$y = \left\lfloor \frac{2^m-1}{2^n-1} x + 0.5 \right\rfloor \qquad (2)$$

In the example given with reference to Figure 1 above, the position of the dashed line will be rounded to the value of y=2 (i.e. bits '10') if equation (2) is used.

Conversely, when doing the opposite operation and converting the m-bit UNORM value, y, to an n-bit UNORM value, x, where n > m equation (3) below may be used.

$$x = \left\lfloor \frac{2^n-1}{2^m-1} y + 0.5 \right\rfloor \qquad (3)$$

Thus, a conversion of an n-bit number to an m-bit number can be performed by performing a sequence of one or more multiplication, division and addition operations. Whilst these multiplication and division operations give a reliable result for the value of y, there is a cost for a hardware implementation in digital logic in terms of the silicon area and processing power, as well as the time taken to compute y by implementing these operations.

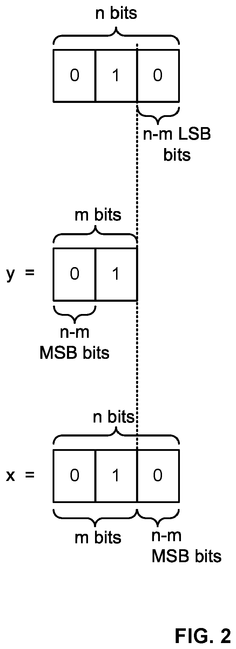

A much simpler technique of converting an unsigned integer (for example a UNORM number) having n bits to m bits and vice versa is to use a truncation method when reducing the number of bits, and a bit replication technique when expanding the number of bits. This method is illustrated in FIG. 2. The n-bit number in binary form can be converted to an m-bit number (where n > m) by simply truncating the n-m least significant bits (LSBs) of the n-bit number. Further the m-bit number can be converted back to an n-bit number by using a technique called bit replication. This involves replicating the n-m most significant bits (MSBs) of the m-bit number to create new LSBs, thus extending the m-bit number to an n-bit number.

A truncation/bit replication technique for converting the n-bit number to m-bit and vice versa is relatively simple to implement, requiring little or no digital logic hardware and provides a result for y relatively quickly (compared to other original method of conversion described above using equation (1)). However, the accuracy of this method is relatively low compared to original method of conversion described above. The method of truncation and bit replication may produce a correct number (result) in some cases (importantly the 0 and 1 cases) as shown in the example illustrated in FIG. 2. But in some other cases the method may not produce a perfectly correct result and will introduce errors. The output may produce a value which may be too large or too small compared to the original number. So, there may be a need to adjust the number, for example up or down by one or more bits.

Provided below is Table 1 illustrating example values for x represented as an n=8 bit number, and corresponding rounded values for y represented as an m=5 bit number, and the further restored version of x by expansion back to n=8 bits from y. This shows the error relative to the original value as a result of this reduction and expansion operation, as well as the overall range of errors. This is illustrated for both the method based on equations (2) and (3) (performing multiplication and division operations) and the truncation and bit replication method. For brevity, not all values of x are shown, but instead only those from 0 to 255 in steps of 6 are illustrated.

**Table 1**

| Input (x) bit depth (n) = 8 | | | | | | |
|---|---|---|---|---|---|---|
| Output (y) bit depth (m) = 5 | | | | | | |
| **Example input step rate: 6** | Error range of examples: -4 to 4 | | | Error range of examples: -7 to 6 | | |
| | Equation (2) & (3) method | | | (Naïve) Truncate and Bit Rep | | |
| Example Values | m-bit result (y) | Restored n-bit result (x) | Error | m-bit result (y) | Restored n-bit result (x) | Error |
| 0 | 0 | 0 | 0 | 0 | 0 | 0 |
| 6 | 1 | 8 | -2 | 0 | 0 | 6 |
| 12 | 1 | 8 | 4 | 1 | 8 | 4 |
| 18 | 2 | 16 | 2 | 2 | 16 | 2 |

(continued)

| Input (x) bit depth (n) = 8 | | | | | | |
|---|---|---|---|---|---|---|
| Output (y) bit depth (m) = 5 | | | | | | |
| **Example input step rate: 6** | Error range of examples: -4 to 4 | | | Error range of examples: -7 to 6 | | |
| | Equation (2) & (3) method | | | (Naïve) Truncate and Bit Rep | | |
| Example Values | m-bit result (y) | Restored n-bit result (x) | Error | m-bit result (y) | Restored n-bit result (x) | Error |
| 24 | 3 | 24 | 0 | 3 | 24 | 0 |
| 30 | 4 | 32 | -2 | 3 | 24 | 6 |
| 36 | 4 | 32 | 4 | 4 | 33 | 3 |
| 42 | 5 | 41 | 1 | 5 | 41 | 1 |
| 48 | 6 | 49 | -1 | 6 | 49 | -1 |
| 54 | 7 | 57 | -3 | 6 | 49 | 5 |
| 60 | 7 | 57 | 3 | 7 | 57 | 3 |
| 66 | 8 | 65 | 1 | 8 | 66 | 0 |
| 72 | 9 | 74 | -2 | 9 | 74 | -2 |
| 78 | 9 | 74 | 4 | 9 | 74 | 4 |
| 84 | 10 | 82 | 2 | 10 | 82 | 2 |
| 90 | 11 | 90 | 0 | 11 | 90 | 0 |
| 96 | 12 | 98 | -2 | 12 | 99 | -3 |
| 102 | 12 | 98 | 4 | 12 | 99 | 3 |
| 108 | 13 | 106 | 2 | 13 | 107 | 1 |
| 114 | 14 | 115 | -1 | 14 | 115 | -1 |
| 120 | 15 | 123 | -3 | 15 | 123 | -3 |
| 126 | 15 | 123 | 3 | 15 | 123 | 3 |
| 132 | 16 | 131 | 1 | 16 | 132 | 0 |
| 138 | 17 | 139 | -1 | 17 | 140 | -2 |
| 144 | 18 | 148 | -4 | 18 | 148 | -4 |
| 150 | 18 | 148 | 2 | 18 | 148 | 2 |
| 156 | 19 | 156 | 0 | 19 | 156 | 0 |
| 162 | 20 | 164 | -2 | 20 | 165 | -3 |
| 168 | 20 | 164 | 4 | 21 | 173 | -5 |
| 174 | 21 | 172 | 2 | 21 | 173 | 1 |
| 180 | 22 | 180 | 0 | 22 | 181 | -1 |
| 186 | 23 | 189 | -3 | 23 | 189 | -3 |
| 192 | 23 | 189 | 3 | 24 | 198 | -6 |
| 198 | 24 | 197 | 1 | 24 | 198 | 0 |
| 204 | 25 | 205 | -1 | 25 | 206 | -2 |
| 210 | 26 | 213 | -3 | 26 | 214 | -4 |
| 216 | 26 | 213 | 3 | 27 | 222 | -6 |
| 222 | 27 | 222 | 0 | 27 | 222 | 0 |

(continued)

| Input (x) bit depth (n) = 8 | | | | | | |
|---|---|---|---|---|---|---|
| Output (y) bit depth (m) = 5 | | | | | | |
| **Example input step rate: 6** | Error range of examples: -4 to 4 | | | Error range of examples: -7 to 6 | | |
| | Equation (2) & (3) method | | | (Naïve) Truncate and Bit Rep | | |
| Example Values | m-bit result (y) | Restored n-bit result (x) | Error | m-bit result (y) | Restored n-bit result (x) | Error |
| 228 | 28 | 230 | -2 | 28 | 231 | -3 |
| 234 | 28 | 230 | 4 | 29 | 239 | -5 |
| 240 | 29 | 238 | 2 | 30 | 247 | -7 |
| 246 | 30 | 246 | 0 | 30 | 247 | -1 |
| 252 | 31 | 255 | -3 | 31 | 255 | -3 |
| 255 | 31 | 255 | 0 | 31 | 255 | 0 |

It is evident from the above table that for values of n=8 bits and m=5 bits for representing the example values from 0 to 255, the rounded m-bit number y using the equation (2) and (3) method and expanded back to the n-bit number (restored n-bit number x) output has an error value that ranges from -4 to +4 whereas the rounded m-bit number y using the truncation method and expanded back to the n-bit number using bit replication (restored n-bit number x) output has an error value that ranges from -7 to +6. Thus, the error increases when the method of truncation and bit replication is used.

Described below is an improved method of rounding or truncating an n-bit number to an m-bit number (where n > m) that can be used instead of a simple truncation (or the more complex formula in equation (2) above) in such a way that when bit replication of the n-m MSBs of the m-bit number is performed to expand back to an n-bit number, a more accurate output is obtained. The new improved rounding method produces better results for all values and bit width combinations compared to simple truncation. Furthermore, this improved technique can match the accuracy of the method in equations (2) and (3), but does so without requiring complex multiply and division operations that are inefficient to implement in digital logic hardware. The new method uses adders and shifters to find a pre-truncation value of an n-bit number which when truncated produces the best lower precision m-bit number, that when expanded back to the n-bit number using bit replication causes minimum error.

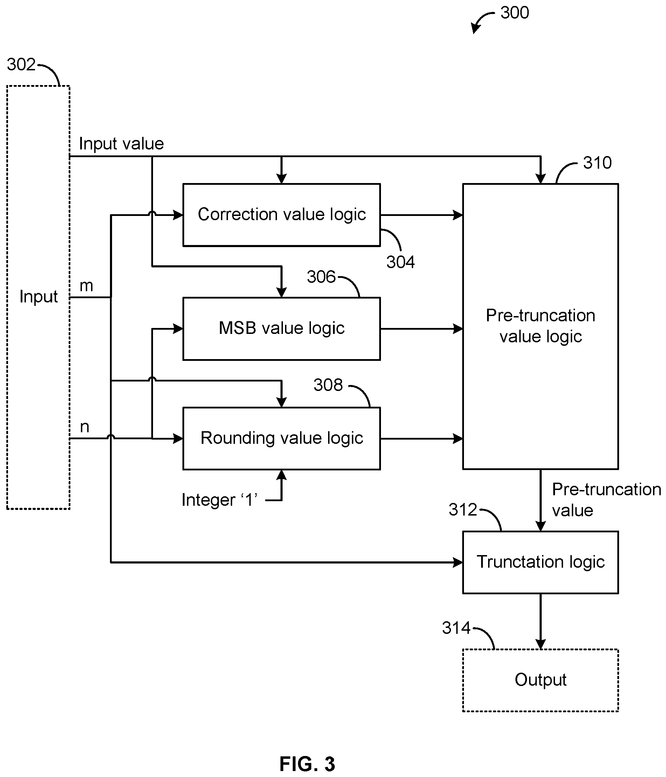

FIG. 3 illustrates a binary logic circuit 300 for rounding an n-bit number to an m-bit number. The binary logic circuit 300 comprises an input 302, correction value logic 304, MSB value logic 306, rounding value logic 308, pre-truncation value logic 310, truncation logic 312, and an output 314. The input 302 is configured to receive the n-bit number (input value) and the values of m and n. The bit length n is greater than bit length m. The binary logic circuit 300 is configured to convert the received n-bit number to obtain a pre-truncation value. The pre-truncation value is another n-bit number which is obtained by correcting the input value using certain parameters. The pre-truncated value (which may also be called a corrected input value) produces an improved lower precision m-bit number when truncated to obtain the rounded m-bit number. As a result, this rounded m-bit number (obtained by rounding the pre-truncation value) causes minimum error when expanded back to the n-bit number using bit replication compared to simply truncating and bit replicating the input value directly.

The correction value logic 304 is configured to generate a correction value having a bit length of n bits for use in the pre-truncation value logic 310. In a first example, the correction value logic 304 may be implemented using a shifter configured to shift the input value to the right by m bits and pad the shifted positions with zero bits to generate a shifted input value as the correction value. In a second example the correction value logic 304 may be implemented using a shifter and NOT logic. The shifter is configured to shift the input value to the right by m bits and pad the shifted positions with zero bits to generate a correction value. The NOT logic further inverts the correction value to generate an inverted correction value. In yet another example the correction value logic 304 may be implemented using a shifter and XOR logic. The XOR logic receives the shifted input value (correction value) as one input and an n-bit number having all high bits as a second input. The XOR logic XORs the two inputs to generate the inverted correction value. In a further example, if the value of m is pre-known, then the correction value can be obtained without a shifter by simply wiring the bit positions of the input value to their shifted positions in the correction value and padding with zeroes (and optionally inverting this as required).

The MSB value logic 306 is configured to determine a result based on the most significant bit (MSB) of the input value for use in the pre-truncation value logic 310. In one example, the MSB value is obtained as a single bit indicating the value of the MSB of the input value. In another example, the MSB value is obtained as an n-bit number having its LSB based on the MSB of the input value and the remaining bits as zero. In a first example, the MSB value logic 306 may be implemented using a shifter and NOT logic. The shifter is configured to shift the input value to the right by n-1 bits (and optionally pad the shifted positions with zero bits if an n-bit number is to be retained) such that the bit value of the MSB of the input value is now located at the LSB position. The result containing the MSB of the input value at the LSB position may be called MSB_VAL. The NOT logic further inverts the LSB of the shifted value to generate an inverted version of the MSB value. The result containing the inverted MSB bit may be called NOT_MSB. In a second example, MSB value logic 306 may be implemented using a shifter configured to shift the input value to the right by n-1 bits (and optionally pad the shifted positions with zero bits if an n-bit number is to be retained) such that the bit value of the MSB of the input value is now located at the LSB position. In this example no inversion occurs and the MSB value logic outputs MSB_VAL. In yet another example, the MSB value logic 306 may be implemented using a shifter and XOR logic. The XOR logic receives the shifted input value (MSB_VAL) as one input and an n-bit number having only the LSB high as a second input. The XOR logic XORs the two inputs to generate the inverted version of the MSB value, NOT_MSB. In a further example, if the value of n is pre-known, then the MSB value of the input can be obtained simply by wiring the MSB bit position of the input value to give MSB_VAL (and optionally padding with zeroes and/or inverting this to produce NOT_MSB as required).

The rounding value logic 308 is configured to generate a rounding value for use in the pre-truncation value logic 310. The rounding value logic 308 is implemented using a shifter. The rounding value logic 308 receives an unsigned integer value of 1 (e.g. an n-bit value with a '1' in the LSB at zeroes at all other bit locations) and shifts the '1' bit to the left by n-m-1 bits to obtain a rounding value. Thus, rounding value is an n-bit number having a high bit at the rounding position or the position at which the truncation needs to be performed and having the remaining bits on both sides equal to zero. For example, for n=8 bit number to be converted to m=5 bit number, the rounding value (or value at the truncation point) would be identified by shifting '1' to the left by 8-5-1 bits. i.e. 00000001<<2 = 00000100. Thus, a '1' bit would be generated at the position 2 from the LSB. Alternatively, if the value of m and n are pre-known, then the rounding value may be generated by the rounding value logic 308 without the use of a shifter by simply setting the appropriate bit at the rounding position (which is known if m and n are pre-known) to high. In a further alternative, instead of using rounding value logic 308, a rounding value (having a high bit at the rounding position or the position at which the truncation needs to be performed and having the remaining bits on both sides equal to zero) may be directly input to the pre-truncation value logic once the value of n and m is known. If the rounding value is known in advance, then the rounding value logic 308 may be omitted and the rounding value provided directly to the pre-truncation value logic 310.

The pre-truncation value logic 310 receives the input value having n bits as a first input. Further the pre-truncation value logic 310 receives the correction value or the inverted correction value from the correction value logic 304, the MSB value (MSB_VAL or the inverted version, NOT_MSB), from the MSB value logic 306, and the rounding value from the rounding value logic 308. The pre-truncation value logic 310 combines the outputs from the correction value logic 304, MSB value logic 306, and rounding value logic 308 and the input value to obtain the pre-truncation value. This is explained in more detail below for different embodiments.

The truncation logic 312 then truncates the pre-truncation value to discard the n-m LSB bits to obtain the rounded m-bit number. The output 314 outputs the m-bit rounded number.

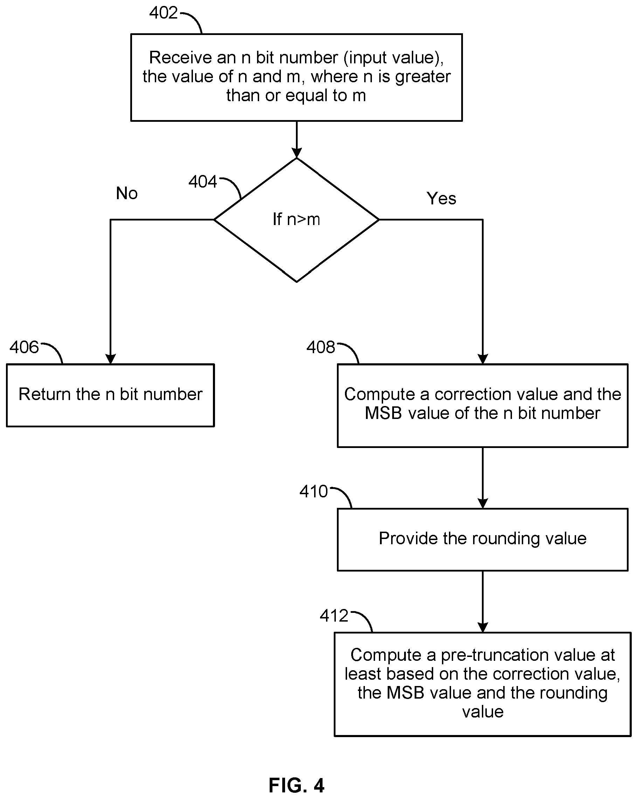

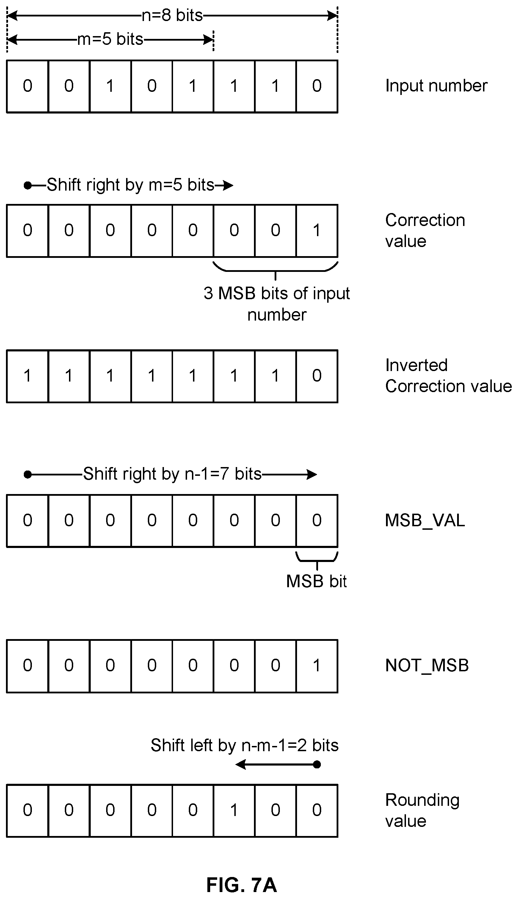

FIG. 4 illustrates a method of rounding an n-bit number to an m-bit number where n is greater than or equal to m. The method includes receiving an input value which is an n-bit number in a binary format, and the values of n and m, at step 402. The n-bit input value includes a first portion representing bits of the number before a rounding point having a bit length of m bits and a second portion representing bits of the number after the rounding point. Consider the example as shown in FIG. 7A where the value of n is 8 and the value of m is 5 and the input value is 46, represented in binary as '0010 1110'. The input value therefore has a first portion representing the 5 MSB bits (i.e. bits of the number before the rounding point having a bit length of m bits) and a second portion representing the 3 LSB bits of the input value (i.e. bits of the number after the rounding point).

At step 404, the method checks if the value of n is greater than m. If value of n is not greater than m, then the method proceeds to step 406. At step 406, the method returns the n-bit number as it is without performing rounding.

If the value of n is greater than m, then the method proceeds to step 408. In the example in FIG. 7A where n=8 bits and m=5 bits, the value of n is greater than the value of m and therefore the method proceeds to step 408. At step 408 the method includes calculating a correction value and the MSB value of the n-bit input value. The correction value is calculated by shifting the received number to the right by m bits and padding the shifted positions with zero bits. In the example in FIG.7A, the input value is shifted to the right by 5 bits. Hence the correction value would be '0000 0001'. The MSB value of the number is identified by shifting the number to the right by n-1 bits and padding the shifted positions with '0' bits. In the example in FIG.7A, the input value is shifted to the right by 7 bits. Hence the MSB value, MSB_VAL, would be '0000 0000'.

Further the method proceeds to step 410 where the rounding value is provided. The rounding value is a number having a high bit at the rounding position of the input value (i.e. at the n-m$^{th}$ position from the first bit). The rounding value can be pre-determined if the value of n and m is known, and provided directly as an input or stored. The rounding point would be the n-m$^{th}$ position from the LSB bit. Hence for n=8 and m=5, the rounding value would be '100', i.e. having a high

bit at the 3rd LSB of the n-bit number. The remaining MSB may be padded with zero bits. The rounding value may also be determined on the fly by shifting a '1' (high) bit to the left by n-m-1 bits thereby positioning the '1' bit at the rounding point.

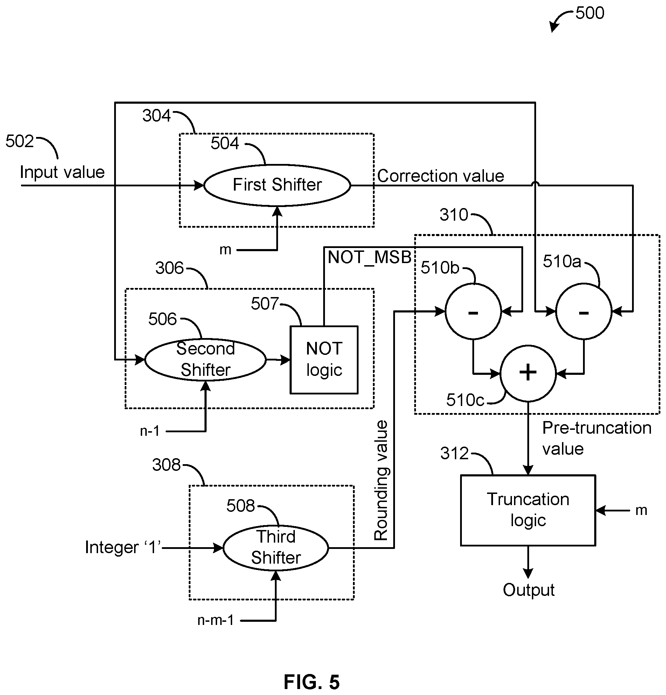

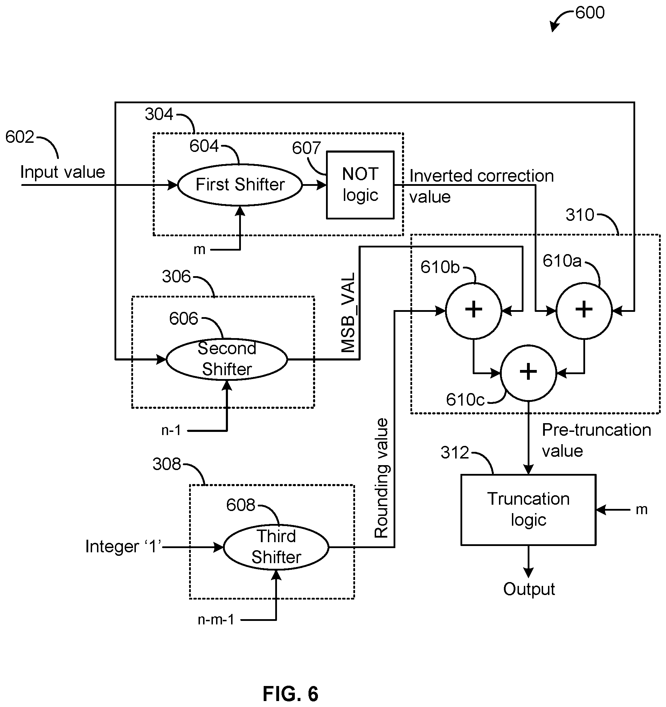

Further the method proceeds to step 412 where the pre-truncation value is determined at least based on the correction value, the MSB value and the rounding value. When the correction value, the MSB value, and the rounding value are combined with the input value by performing one or more addition/subtraction operations, the carryover from the operation will ripple all the way up to the required point generating the pre-truncation value that provides the correct rounded number output when truncated. Once the pre-truncation value is determined the n-m LSB bits are discarded to obtain the rounded m-bit number. The calculation of the pre-truncation value is explained in detail below with respect to FIG. 5 and FIG. 6.

In one embodiment, the pre-truncation value is determined by performing the following operations on the received input value. The operations include adding the rounding value and subtracting both the correction value and the inverted MSB value (NOT_MSB) from the input value. In this embodiment the multiplication and division operation in the original method of conversion described above using equation (2) is replaced with addition and subtraction operations hence reducing the complexity of the operation (the time taken to compute y by implementing these operations) as well as cost in terms of the silicon area and processing power.

In another embodiment, the pre-truncation value is determined by performing the following operations on the received input value. The operations include adding the inverted correction value, the rounding value and the MSB value (MSB_VAL) to the input value. In this embodiment the multiplication and division operation in the original method of conversion described above using equation (2) is replaced with addition operations hence reducing the complexity of the operation (the time taken to compute y by implementing these operations) as well as cost in terms of the silicon area and processing power further.

In a hardware implementation of the binary logic circuit, the operation produces an n-bit pre-truncation value. When the technique is implemented in software, the CPU registers may have a bit length greater than n bits. When adding the inverted correction value, rounding value and the MSB value of the received number to the received input value, the bits of the output (i.e. pre-truncation value) may overflow causing the pre-truncation value to have more than n bits. Hence when implemented in software, an n-bit mask is used to generate an n-bit pre-truncation value. The n-bit mask is applied to the output by performing a bitwise AND operation to generate an n-bit pre-truncation value. The n-bit mask is a number having n '1' bits. The n-bit mask may be obtained by shifting the unsigned value '1' to the left by n bit positions and subtracting one from the result.

FIG. 5 illustrates a first embodiment (circuit 500) of binary logic circuit 300 for rounding an n-bit number to an m-bit number. The circuit 500 comprises an input 502 configured to receive the n-bit input value. The bit length n is greater than bit length m. As explained in connection with FIG.7A above, consider the example where the value of n is 8 and the value of m is 5 and the input value is 46, represented in binary as '0010 1110'.

In the circuit 500, in the first embodiment, the correction value logic 304 in the binary logic circuit 300 may be implemented using a first shifter 504 configured to shift the input value to the right by m bits and pad the shifted positions with zero bits to generate a shifted input value which is the correction value. As explained in the above example in FIG.7A, the input value is shifted to the right by 5 bits. Hence the correction value would be '0000 0001'.

In the circuit 500, the MSB value logic 306 may be implemented using a second shifter 506 and NOT logic 507. The shifter 506 is configured to shift the input value to the right by n-1 bits and pad the shifted positions with '0' bits to generate an n-bit number having the value of the input MSB at its LSB. As explained in the above example in FIG.7A, the input value is shifted to the right by 7 bits. Hence the MSB value would be '0000 0000'. The NOT logic operator further inverts the LSB of the shifted value to generate an inverted MSB value, NOT_MSB. The NOT_MSB value generated would hence be '0000 0001'. This is shown in FIG. 7A. Instead of using a NOT operator an XOR logic operator may be used to generate NOT_MSB.

Further in circuit 500, the rounding value logic 308 may be implemented using a third shifter 508. The shifter 508 receives a single bit '1' as an input. The shifter 508 is configured to shift the '1' to the left by n-m-1 bits and pad the remaining bits with '0' bits to generate an n-bit number having a high bit at the rounding point. As explained in the above example in FIG.7A, the '1' bit is shifted to the right by 8-5-1=2 bits. Hence the rounding value is '0000 0100'. The rounding value logic 308 can be eliminated if the rounding value is precomputed based on the value of n and m as explained earlier.

In the circuit 500, the pre-truncation value logic 310 determines the pre-truncation value at least based on the correction value, the NOT_MSB value and the rounding value. In the circuit 500, the pre-truncation value logic 310 may be implemented using one or more subtractors 510a and 510b and an adder 510c. The calculation of the pre-truncation value may be expressed by an equation as given below:

$$\text{Pre truncation value} = \text{Input Value} - \text{Correction Value} + \text{Rounding value} - \text{NOT\_MSB} \qquad (4)$$

The equation (4) may be reordered to generate various equivalent combinations achieving the same effect, as will be appreciated by the skilled person. FIG. 5 illustrates the pre-truncation value logic implemented as a binary circuit having 2 subtractors, first subtractor 510a subtracting the correction value from the input value and a second subtractor subtracting the NOT_MSB value from the rounding unit and an adder adding the output from the first subtractor 510a and the second subtractor 510b. The pre-truncation value logic may be implemented by different combinations such as first subtractor 510a subtracting the correction value from the input value, an adder adding the output from the first subtractor 510a to the rounding value and a second subtractor subtracting the NOT_MSB value from output of the adder. Various other combinations of the subtractors and adder are also possible.

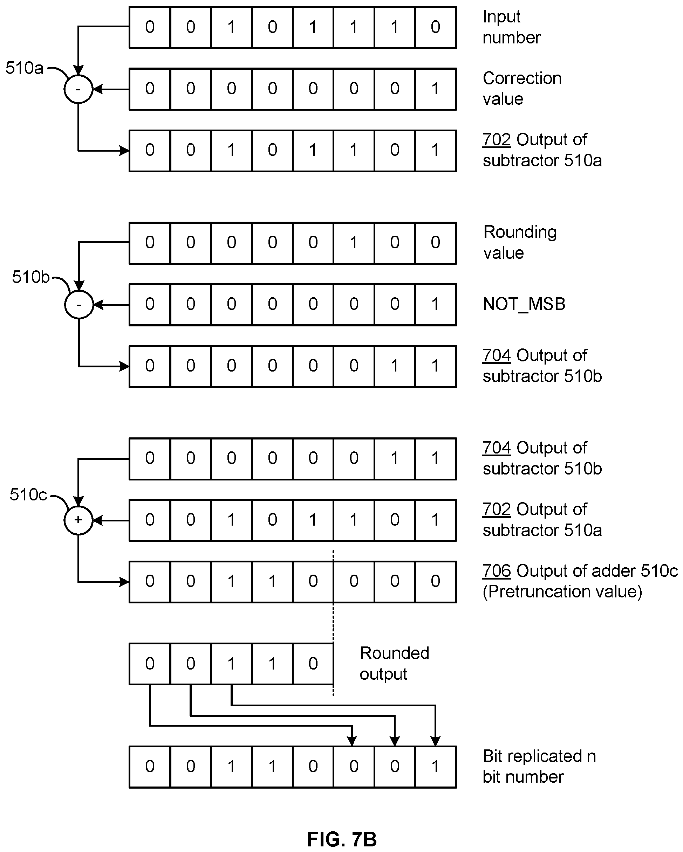

In FIG. 5, the first subtractor 510a receives the input value having n bits as the first input from the input 502 and the correction value as a second input from the first shifter 504. FIG. 7B shows the subtractor 510a receiving the input value '0010 1110' as first input and correction value '0000 0001' as second input. The subtractor 510a subtracts the correction value from the input value producing a first output '0010 1101'. This is shown in FIG. 7B as output 702. The subtractor 510b receives the rounding value as the first input from the third shifter 508 and the NOT_MSB value as a second input from the NOT operator 507. FIG. 7B shows the subtractor 510b receiving the rounding value '0000 0100' as first input and NOT_MSB, containing a '1' in the least significant bit position as the second input. The subtractor 510b subtracts NOT_MSB from the rounding value producing a second output '0000 0011'. This is shown in FIG. 7B as output 704. Further, the adder 510 receives the first output 702 and second output 704 from the subtractors 510a and 510b. The adder adds the first output '0010 1101' and second output '0000 0011' generating the pre-truncation value '0011 0000' (706 in FIG. 7B).

Further, the truncation logic 312 truncates the pre-truncation value to discard the n-m LSB bits to obtain the rounded m-bit number. As shown in FIG. 7B, the rounding unit discards 8-5=3 LSBs of the pre-truncated result thereby obtaining the rounded output number as '00110'. The output 314 outputs the m-bit rounded number '00110'. Further when performing bit replication to restore the n-bit number, the first 3 MSBs are added as the 3 LSBs of the rounded number thereby generating a restored n-bit number '0011 0001' which represents the value 49 in decimal. Hence the error introduced is +3 in this example.

FIG. 6 illustrates a second embodiment (circuit 600) of binary logic circuit 300 for rounding an n-bit number to an m-bit number. The circuit 600 comprises an input 602 configured to receive the n-bit input value. The bit length n is greater than bit length m. As explained in connection with FIG.7A above, consider the example where the value of n is 8 and the value of m is 5 and the input value is 46, represented in binary as '0010 1110'.

In the circuit 600, in the second embodiment, the correction value logic 304 in the binary logic circuit 300 may be implemented using a first shifter 604 and NOT logic 607. The first shifter 604 is configured to shift the input value to the right by m bits and pad the shifted positions with '0' bits to generate a shifted value input which is the correction value. As explained in the above example in FIG.7A, the input value is shifted to the right by 5 bits. Hence the correction value would be '0000 0001'. The NOT logic 607 further inverts the correction value to generate an inverted correction value. The inverted correction value generated is '1111 1110' in this example. This is shown in FIG. 7A. Instead of using a NOT operator an XOR logic operator may be used to generate the inverted correction value.

In the circuit 600, the MSB value logic 306 may be implemented using a second shifter 606. The shifter 606 is configured to shift the input value to the right by n-1 bits and pad the shifted positions with '0' bits to generate an n-bit number, MSB_VAL, having the input MSB at its LSB. As explained in the above example in FIG.7A, the input value is shifted to the right by 7 bits. Hence the MSB_VAL would be '0000 0000'.

Further in circuit 600, the rounding value logic 308 may be implemented using a third shifter 608 to generate the rounding value as explained earlier with respect to FIG. 5 and FIG. 7A. Thus, the third shifter 608 shifts the '1' to the right by 8-5-1=2 bits. Hence the rounding value is '0000 0100' in this example. The rounding value logic 308 can be eliminated if the rounding value is precomputed based on the value of n and m as explained earlier.

In the circuit 600, the pre-truncation value logic 310 determines the pre-truncation value at least based on the correction value, the MSB_VAL value and the rounding value. In the circuit 600, the pre-truncation value logic 310 may be implemented using a plurality of adders 610a, 610b and an 610c. The pre-truncation value is calculated by an equation as given below:

$$\text{Pre truncation value} = \text{Input value} + \text{Inverted Correction Value} + \text{Rounding value} + \text{MSB\_VAL} \quad (5)$$

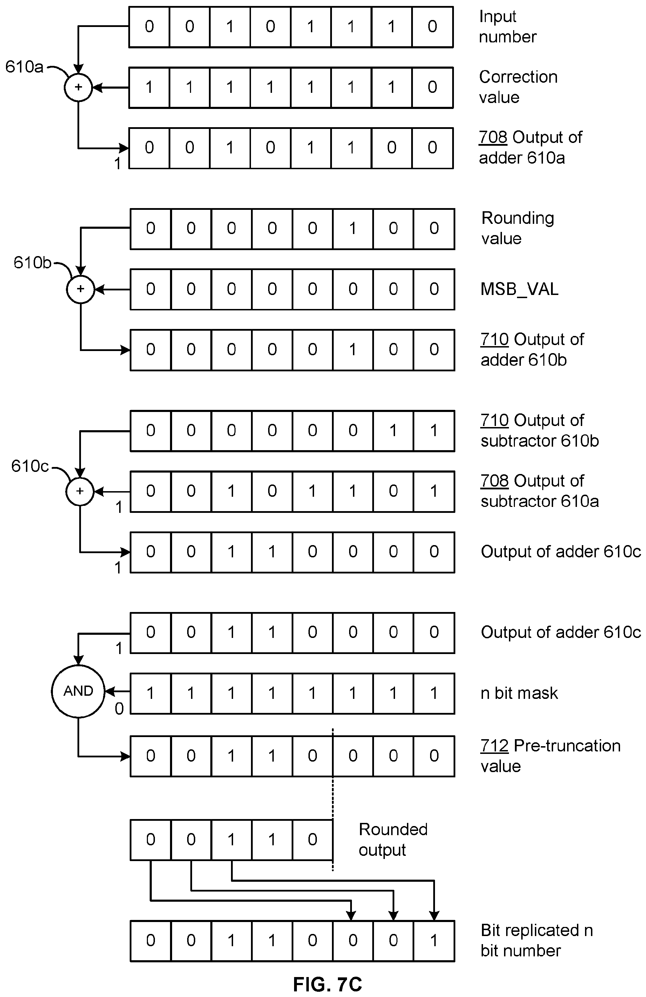

In FIG. 6, the first adder 610a receives the value input having n bits as the first input from the input 602 and the inverted correction value as a second input from the NOT logic 607. The example of FIG. 7C shows the adder 610a receiving the input value '0010 1110' as first input and correction value '1111 1110' as second input. The adder 610a adds the correction value to the input value producing a first output '1 0010 1100' (708 in FIG. 7C). In the binary circuit 600, the overflow bit is not considered as it overflows and may be discarded. However, when the binary circuit 600 is implemented in software, the CPU registers may be able to accommodate numbers having bit length greater than n. Hence the first output could be stored as '1 0010 1100'. This is shown in FIG. 7C. The adder 610b receives the rounding value as the first input from the third shifter 608 and MSB_VAL as a second input from the second shifter 606. FIG. 7C shows the adder 610b receiving the rounding value '0000 0100' as first input and MSB_VAL containing a '0' in the least significant bit position as the second input. The adder 610b adds MSB_VAL to the rounding value producing a second output '0000 0100' (710 in FIG. 7C). This is also shown in FIG. 7C. Further, the adder 610c receives the first output and second output from the adders 610a and 610b. In FIG. 7C, the adder adds the first output '1 0010 1100' and second output '0000 0100' generating the pre-truncation value '1 0011 0000' (712 in FIG. 7C). Again, as mentioned earlier, for a hardware circuit the overflow bit is not considered and hence the pre-truncation value would be '0011 0000'. However, for a software implementation the pre-truncation value having n bits needs to be determined. This is done by using an n-bit mask having the n least significant bits all set high and all other bits low. Thus, to obtain the pre-truncation value having n bits a bitwise AND operation of the output of the third adder 610c with the n-bit mask is performed as illustrated in FIG. 7C. Note that in alternative examples, an n-bit mask can be applied in one or more other locations to handle overflows, for example at the output of the adders 610a, 610b and/or 610c.

Further, the truncation logic 312 truncates the pre-truncation value to discard the n-m LSB bits to obtain the rounded m-bit number. As shown in FIG. 7C, the rounding unit discards 8-5=3 LSBs of the pre-truncated result thereby obtaining the rounded output number as '00110'. The output 314 outputs the m-bit rounded number '00110'. Further when performing bit replication to restore the n-bit number, the first 3 MSBs are added as the 3 LSBs of the rounded number thereby generating a restored n-bit number '0011 0001' which represents the value 49 in decimal. Hence the error introduced is +3.

Thus, the output generated by both circuits 500 and 600 are the same. This can be shown to be the case for all inputs. Circuit 600 may be preferred in some cases because it only uses adders, whereas the circuit 500 uses an adder and subtractors. However, the two circuits may have other relative advantages for different forms of hardware implementation, as will be apparent to the skilled person. The circuits 500 and 600 reduce the complexity of the operation (the time taken to compute the output) by requiring only shift, addition and/or subtraction operations, as well as reducing the silicon area and power consumption compared to the original method of that requires multiplication and division operations. Furthermore, the error introduced in the output is the same as that introduced when performing the original method to find the rounded output having m bits and the bit replicated n-bit number. Hence the error introduced when determining the rounded output having m bits and subsequently bit replicating back to an n-bit number is far better than that achieved when using performing the rounding to m bits using the uncorrected, direct truncation method.

This can be illustrated using the example input value of FIG. 7A, and the error introduced by using the direct (uncorrected) truncation and bit replication method compared. The input value from FIG. 7A was 46 in decimal, represented in binary as '0010 1110'. When performing direct (uncorrected) truncation, to obtain a truncated/rounded m-bit number, the n-m LSBs of the n-bit value input are discarded. The value of n is 8 and m is 5 as in FIG 7A-C. Thus, using the direct (uncorrected) truncation, the 8-5=3 LSBs of the input value are discarded generating the truncated/rounded m-bit number as '00101'. Consequently, when performing bit replication to restore the n-bit number, the first 3 MSBs are added as the 3 LSBs of the rounded number thereby generating a restored n-bit number. In this example the first 3 MSBs '001' of the rounded m-bit number '00101' are added as the 3 LSBs of the rounded number thereby generating a restored n-bit number of '0010 1001', which represents the value 41 in decimal. Hence the error introduced is -5 which is greater than the error introduced by the improved method explained with respect to FIGs 7A-C.

Provided below is Table 2 illustrating the example input values, x and y values (in decimal) represented as m-bit numbers and n-bit numbers and the error range of the example the improved method. This also shows the intermediate values calculated for the rounding value, MSB_VAL, NOT MSB, correction value, and pre-truncation value. The example input values are same as the example values given in Table 1.

**Table 2**

| Input (x) bit depth (n) = 8 | | | | | | | | |
|---|---|---|---|---|---|---|---|---|
| Output (y) bit depth (m) = 5 | | | | | | | | |
| **Example input step Rate: 6** | Error Range of example: -4 to 4 | | | | | | | |
| | Improved Rounding Method Plus Bit Replication | | | | | | | |
| Example Values | Rounding value | MSB_VAL | NOT_MSB | Correction Value | Pre-Truncation value | m-bit result (y) | Restored n-bit result (x) | Error |
| 0 | 4 | 0 | 1 | 0 | 3 | 0 | 0 | 0 |
| 6 | 4 | 0 | 1 | 0 | 9 | 1 | 8 | -2 |
| 12 | 4 | 0 | 1 | 0 | 15 | 1 | 8 | 4 |
| 18 | 4 | 0 | 1 | 0 | 21 | 2 | 16 | 2 |

(continued)

| Input (x) bit depth (n) = 8 | | | | | | | | |
|---|---|---|---|---|---|---|---|---|
| Output (y) bit depth (m) = 5 | | | | | | | | |
| **Example input step Rate: 6** | Error Range of example: -4 to 4 | | | | | | | |
| | **Improved Rounding Method Plus Bit Replication** | | | | | | | |
| Example Values | Rounding value | MSB_VAL | NOT_MSB | Correction Value | Pre-Truncation value | m-bit result (y) | Restored n-bit result (x) | Error |
| 24 | 4 | 0 | 1 | 0 | 27 | 3 | 24 | 0 |
| 30 | 4 | 0 | 1 | 0 | 33 | 4 | 33 | -3 |
| 36 | 4 | 0 | 1 | 1 | 38 | 4 | 33 | 3 |
| 42 | 4 | 0 | 1 | 1 | 44 | 5 | 41 | 1 |
| 48 | 4 | 0 | 1 | 1 | 50 | 6 | 49 | -1 |
| 54 | 4 | 0 | 1 | 1 | 56 | 7 | 57 | -3 |
| 60 | 4 | 0 | 1 | 1 | 62 | 7 | 57 | 3 |
| 66 | 4 | 0 | 1 | 2 | 67 | 8 | 66 | 0 |
| 72 | 4 | 0 | 1 | 2 | 73 | 9 | 74 | -2 |
| 78 | 4 | 0 | 1 | 2 | 79 | 9 | 74 | 4 |
| 84 | 4 | 0 | 1 | 2 | 85 | 10 | 82 | 2 |
| 90 | 4 | 0 | 1 | 2 | 91 | 11 | 90 | 0 |
| 96 | 4 | 0 | 1 | 3 | 96 | 12 | 99 | -3 |
| 102 | 4 | 0 | 1 | 3 | 102 | 12 | 99 | 3 |
| 108 | 4 | 0 | 1 | 3 | 108 | 13 | 107 | 1 |
| 114 | 4 | 0 | 1 | 3 | 114 | 14 | 115 | -1 |
| 120 | 4 | 0 | 1 | 3 | 120 | 15 | 123 | -3 |
| 126 | 4 | 0 | 1 | 3 | 126 | 15 | 123 | 3 |
| 132 | 4 | 1 | 0 | 4 | 132 | 16 | 132 | 0 |
| 138 | 4 | 1 | 0 | 4 | 138 | 17 | 140 | -2 |
| 144 | 4 | 1 | 0 | 4 | 144 | 18 | 148 | -4 |
| 150 | 4 | 1 | 0 | 4 | 150 | 18 | 148 | 2 |
| 156 | 4 | 1 | 0 | 4 | 156 | 19 | 156 | 0 |
| 162 | 4 | 1 | 0 | 5 | 161 | 20 | 165 | -3 |
| 168 | 4 | 1 | 0 | 5 | 167 | 20 | 165 | 3 |
| 174 | 4 | 1 | 0 | 5 | 173 | 21 | 173 | 1 |
| 180 | 4 | 1 | 0 | 5 | 179 | 22 | 181 | -1 |
| 186 | 4 | 1 | 0 | 5 | 185 | 23 | 189 | -3 |
| 192 | 4 | 1 | 0 | 6 | 190 | 23 | 189 | 3 |
| 198 | 4 | 1 | 0 | 6 | 196 | 24 | 198 | 0 |
| 204 | 4 | 1 | 0 | 6 | 202 | 25 | 206 | -2 |
| 210 | 4 | 1 | 0 | 6 | 208 | 26 | 214 | -4 |
| 216 | 4 | 1 | 0 | 6 | 214 | 26 | 214 | 2 |

(continued)

| Input (x) bit depth (n) = 8 | | | | | | | | |
|---|---|---|---|---|---|---|---|---|
| Output (y) bit depth (m) = 5 | | | | | | | | |
| Example input step Rate: 6 | Error Range of example: -4 to 4 | | | | | | | |
| | Improved Rounding Method Plus Bit Replication | | | | | | | |
| Example Values | Rounding value | MSB_VAL | NOT_MSB | Correction Value | Pre-Truncation value | m-bit result (y) | Restored n-bit result (x) | Error |
| 222 | 4 | 1 | 0 | 6 | 220 | 27 | 222 | 0 |
| 228 | 4 | 1 | 0 | 7 | 225 | 28 | 231 | -3 |
| 234 | 4 | 1 | 0 | 7 | 231 | 28 | 231 | 3 |
| 240 | 4 | 1 | 0 | 7 | 237 | 29 | 239 | 1 |
| 246 | 4 | 1 | 0 | 7 | 243 | 30 | 247 | -1 |
| 252 | 4 | 1 | 0 | 7 | 249 | 31 | 255 | -3 |
| 255 | 4 | 1 | 0 | 7 | 252 | 31 | 255 | 0 |

The conversion of n-bit numbers to m-bit numbers and conversion back to n-bit numbers using the improved method (explained with respect to FIGs 3, 4, 5, 6 and 7A to 7C) may be used in various image compression and decompression methods where a value of a pixel in an image is converted from an n-bit number to an m-bit number during compression and later converted back to n-bit number during decompression. When using the improved method for rounding or truncating the n-bit number to an m-bit number and re-expanding back to the n-bit number using bit replicating method during image compression and decompression, the accuracy of the result obtained would match with the accuracy of the result obtained when using the method in equation (2) and (3). Further, the conversion of n-bit numbers to m-bit numbers and conversion back to n-bit numbers in compression and decompression systems can be implemented with a much simpler operations such as bit shifting, addition and subtraction without requiring complex multiply and division operations that are inefficient to implement in digital logic hardware.

The idea can be used elsewhere, where a number having a wider bit width is converted to a number having a smaller bit width such as for representing an audio signal that has values in the range [0.0, 1.0] (i.e. inclusive of 0 and 1)

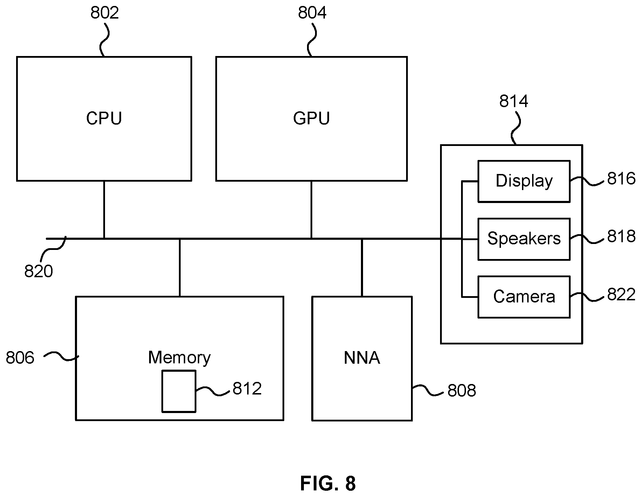

FIG. 8 shows a computer system in which the binary logic circuits described herein may be implemented. The computer system comprises a CPU 802, a GPU 804, a memory 806, a neural network accelerator (NNA) 808 and other devices 814, such as a display 816, speakers 818 and a camera 822. The components of the computer system can communicate with each other via a communications bus 820. A store 812 is implemented as part of the memory 806. A binary logic circuit for rounding a number may be used, for example, within the GPU 804, CPU 802 and/or neural network accelerator (NNA) 808.

The binary logic circuits of Figures 3-6 are shown as comprising a number of functional blocks. This is schematic only and is not intended to define a strict division between different logic elements of such entities. Each functional block may be provided in any suitable manner. It is to be understood that intermediate values described herein as being formed by a binary logic circuit need not be physically generated by the binary logic circuit at any point and may merely represent logical values which conveniently describe the processing performed by the binary logic circuit between its input and output.

The binary logic circuits described herein may be embodied in hardware on an integrated circuit. The binary logic circuits described herein may be configured to perform any of the methods described herein. Generally, any of the functions, methods, techniques or components described above can be implemented in software, firmware, hardware (e.g., fixed logic circuitry), or any combination thereof. The terms "module," "functionality," "component", "element", "unit", "block" and "logic" may be used herein to generally represent software, firmware, hardware, or any combination thereof. In the case of a software implementation, the module, functionality, component, element, unit, block or logic represents program code that performs the specified tasks when executed on a processor. The algorithms and methods described herein could be performed by one or more processors executing code that causes the processor(s) to perform the algorithms/methods. Examples of a computer-readable storage medium include a random-access memory (RAM), read-only memory (ROM), an optical disc, flash memory, hard disk memory, and other memory devices that may use magnetic, optical, and other techniques to store instructions or other data and that can be accessed by a machine.

The terms computer program code and computer readable instructions as used herein refer to any kind of executable code for processors, including code expressed in a machine language, an interpreted language or a scripting language. Executable code includes binary code, machine code, bytecode, code defining an integrated circuit (such as a hardware description language or netlist), and code expressed in a programming language code such as C, Java or OpenCL. Executable code may be, for example, any kind of software, firmware, script, module or library which, when suitably executed, processed, interpreted, compiled, executed at a virtual machine or other software environment, cause a processor of the computer system at which the executable code is supported to perform the tasks specified by the code.

A processor, computer, or computer system may be any kind of device, machine or dedicated circuit, or collection or portion thereof, with processing capability such that it can execute instructions. A processor may be or comprise any kind of general purpose or dedicated processor, such as a CPU, GPU, NNA, System-on-chip, state machine, media processor, an application-specific integrated circuit (ASIC), a programmable logic array, a field-programmable gate array (FPGA), or the like. A computer or computer system may comprise one or more processors.

It is also intended to encompass software which defines a configuration of hardware as described herein, such as HDL (hardware description language) software, as is used for designing integrated circuits, or for configuring programmable chips, to carry out desired functions. That is, there may be provided a computer readable storage medium having encoded thereon computer readable program code in the form of an integrated circuit definition dataset that when processed (i.e. run) in an integrated circuit manufacturing system configures the system to manufacture a binary logic circuit configured to perform any of the methods described herein, or to manufacture a binary logic circuit comprising any apparatus described herein. An integrated circuit definition dataset may be, for example, an integrated circuit description.

Therefore, there may be provided a method of manufacturing, at an integrated circuit manufacturing system, a binary logic circuit as described herein. Furthermore, there may be provided an integrated circuit definition dataset that, when processed in an integrated circuit manufacturing system, causes the method of manufacturing a binary logic circuit to be performed.

An integrated circuit definition dataset may be in the form of computer code, for example as a netlist, code for configuring a programmable chip, as a hardware description language defining hardware suitable for manufacture in an integrated circuit at any level, including as register transfer level (RTL) code, as high-level circuit representations such as Verilog or VHDL, and as low-level circuit representations such as OASIS (RTM) and GDSII. Higher level representations which logically define hardware suitable for manufacture in an integrated circuit (such as RTL) may be processed at a computer system configured for generating a manufacturing definition of an integrated circuit in the context of a software environment comprising definitions of circuit elements and rules for combining those elements in order to generate the manufacturing definition of an integrated circuit so defined by the representation. As is typically the case with software executing at a computer system so as to define a machine, one or more intermediate user steps (e.g. providing commands, variables etc.) may be required in order for a computer system configured for generating a manufacturing definition of an integrated circuit to execute code defining an integrated circuit so as to generate the manufacturing definition of that integrated circuit.

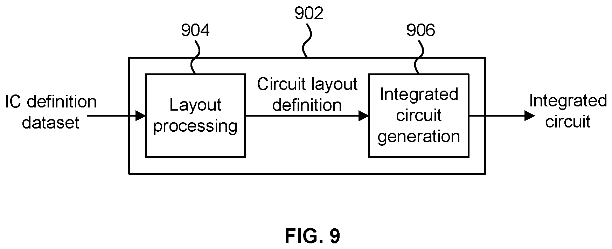

An example of processing an integrated circuit definition dataset at an integrated circuit manufacturing system so as to configure the system to manufacture a binary logic circuit will now be described with respect to FIG. 9

FIG. 9 shows an example of an integrated circuit (IC) manufacturing system 902 which is configured to manufacture a binary logic circuit as described in any of the examples herein. In particular, the IC manufacturing system 902 comprises a layout processing system 904 and an integrated circuit generation system 906. The IC manufacturing system 902 is configured to receive an IC definition dataset (e.g. defining a binary logic circuit as described in any of the examples herein), process the IC definition dataset, and generate an IC according to the IC definition dataset (e.g. which embodies a binary logic circuit as described in any of the examples herein). The processing of the IC definition dataset configures the IC manufacturing system 902 to manufacture an integrated circuit embodying a binary logic circuit as described in any of the examples herein.

The layout processing system 904 is configured to receive and process the IC definition dataset to determine a circuit layout. Methods of determining a circuit layout from an IC definition dataset are known in the art, and for example may involve synthesising RTL code to determine a gate level representation of a circuit to be generated, e.g. in terms of logical components (e.g. NAND, NOR, AND, OR, MUX and FLIP-FLOP components). A circuit layout can be determined from the gate level representation of the circuit by determining positional information for the logical components. This may be done automatically or with user involvement in order to optimise the circuit layout. When the layout processing system 904 has determined the circuit layout it may output a circuit layout definition to the IC generation system 906. A circuit layout definition may be, for example, a circuit layout description.

The IC generation system 906 generates an IC according to the circuit layout definition, as is known in the art. For example, the IC generation system 906 may implement a semiconductor device fabrication process to generate the IC, which may involve a multiple-step sequence of photo lithographic and chemical processing steps during which electronic circuits are gradually created on a wafer made of semiconducting material. The circuit layout definition may be in the form of a mask which can be used in a lithographic process for generating an IC according to the circuit definition. Alternatively, the circuit layout definition provided to the IC generation system 906 may be in the form of computer-readable code which the IC generation system 906 can use to form a suitable mask for use in generating an IC.

The different processes performed by the IC manufacturing system 902 may be implemented all in one location, e.g. by one party. Alternatively, the IC manufacturing system 902 may be a distributed system such that some of the processes may be performed at different locations, and may be performed by different parties. For example, some of the stages of: (i) synthesising RTL code representing the IC definition dataset to form a gate level representation of a circuit to be generated, (ii) generating a circuit layout based on the gate level representation, (iii) forming a mask in accordance with the circuit layout, and (iv) fabricating an integrated circuit using the mask, may be performed in different locations and/or by different parties.

In other examples, processing of the integrated circuit definition dataset at an integrated circuit manufacturing system may configure the system to manufacture a binary logic circuit without the IC definition dataset being processed so as to determine a circuit layout. For instance, an integrated circuit definition dataset may define the configuration of a reconfigurable processor, such as an FPGA, and the processing of that dataset may configure an IC manufacturing system to generate a reconfigurable processor having that defined configuration (e.g. by loading configuration data to the FPGA).

In some embodiments, an integrated circuit manufacturing definition dataset, when processed in an integrated circuit manufacturing system, may cause an integrated circuit manufacturing system to generate a device as described herein. For example, the configuration of an integrated circuit manufacturing system in the manner described above with respect to Figure 9 by an integrated circuit manufacturing definition dataset may cause a device as described herein to be manufactured.

In some examples, an integrated circuit definition dataset could include software which runs on hardware defined at the dataset or in combination with hardware defined at the dataset. In the example shown in Figure 9, the IC generation system may further be configured by an integrated circuit definition dataset to, on manufacturing an integrated circuit, load firmware onto that integrated circuit in accordance with program code defined at the integrated circuit definition dataset or otherwise provide program code with the integrated circuit for use with the integrated circuit.

The implementation of concepts set forth in this application in devices, apparatus, modules, and/or systems (as well as in methods implemented herein) may give rise to performance improvements when compared with known implementations. The performance improvements may include one or more of increased computational performance, reduced latency, increased throughput, and/or reduced power consumption. During manufacture of such devices, apparatus, modules, and systems (e.g. in integrated circuits) performance improvements can be traded-off against the physical implementation, thereby improving the method of manufacture. For example, a performance improvement may be traded against layout area, thereby matching the performance of a known implementation but using less silicon. This may be done, for example, by reusing functional blocks in a serialised fashion or sharing functional blocks between elements of the devices, apparatus, modules and/or systems. Conversely, concepts set forth in this application that give rise to improvements in the physical implementation of the devices, apparatus, modules, and systems (such as reduced silicon area) may be traded for improved performance. This may be done, for example, by manufacturing multiple instances of a module within a predefined area budget.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein. In view of the foregoing description it will be evident to a person skilled in the art that various modifications may be made.

**Claims**

1. A computer-implemented method of rounding an unsigned normalised n-bit number to an m-bit number, where $n > m > 0$, the method comprising:

   receiving the n-bit number in a binary format;
   **characterised by**
   determining a correction value having a bit length of n bits, wherein determining the correction value comprises right shifting the n-bit number by m bits;
   determining a pre-truncation value having a bit length of n bits based on the n-bit number, the correction value, a value for the most significant bit (MSB) of the n-bit number, and a rounding value having a '1' at the n-m$^{th}$ bit position and a '0' at all other bits, wherein the pre-truncation value is determined by performing one or more addition and/or subtraction operations on the n-bit number, the rounding value, the correction value and the value for the MSB of the n-bit number; and
   obtaining the rounded m-bit number by truncating the n-m least significant bits (LSB) of the pre-truncation value.

2. The computer-implemented method as claimed in any preceding claim, wherein the rounding value is determined by shifting a value of '1' to the left by n-m-1 bits thereby positioning a 1 bit at the n-m$^{th}$ bit position.

3. The computer-implemented method as claimed in any preceding claim, wherein the value for the MSB of the n-bit number is identified by shifting the number to the right by n-1 bits.

4. The computer-implemented method as claimed in any preceding claim, wherein determining a pre-truncation value comprises:

   subtracting the correction value from the n-bit number;
   subtracting an inverted version of the value for the MSB from the rounding value; and
   adding the output from the two subtractions to generate the pre-truncation value.

5. The computer-implemented method as claimed in claim 4, wherein the inverted version of the value for the MSB is obtained by performing a NOT operation on the LSB of the value for the MSB.

6. The computer-implemented method as claimed in any of claims 1 to 3, wherein determining a pre-truncation value comprises:

   inverting the correction value; and
   adding the inverted correction value, rounding value and the value for the MSB of the n-bit number to the n-bit number to generate the pre-truncation value.

7. The computer-implemented method as claimed in claim 6, wherein inverting the correction value comprises performing a NOT operation on the bits of the correction value.

8. A binary logic circuit for rounding an unsigned normalised n-bit number to an m-bit number, where n > m > 0, the binary logic circuit comprising:

   an input configured to receive the n-bit number;
   **characterised by** further comprising:

   correction value logic configured to generate a correction value having a bit length of n bits. the logic comprising a shifter for right shifting the n-bit number by m bits;
   MSB value logic configured to determine a value for the most significant bit (MSB) of the n-bit number;
   pre-truncation value logic configured to determine a pre-truncation value having a bit length of n bits based on the n-bit number, the correction value, the value for the MSB of the received number, and a rounding value having a '1' at the n-m$^{th}$ bit position and a '0' at all other bits, wherein the pre-truncation value logic performs one or more addition and/or subtraction operations on the n-bit number, the rounding value, the correction value and the value for the MSB of the n-bit number to determine the pre-truncation value;
   truncation logic configured to truncate the pre-truncation value by discarding the n-m LSB bits to obtain a rounded m-bit number; and
   an output configured to output the rounded m-bit number.

9. The binary logic circuit as claimed in claim 8, further comprising rounding value logic configured to determine the rounding value by shifting value of '1' to the left by n-m-1 bits thereby positioning a '1' bit at the n-m$^{th}$ bit position.

10. The binary logic circuit as claimed in any of claims 8 or 9, wherein the MSB value logic identifies the value for the MSB of the number by shifting the number to the right by n-1 bits.

11. The binary logic circuit of any of claims 8 to 10, wherein the binary logic circuit is embodied in hardware on an integrated circuit.

12. An image compression circuit comprising the binary logic circuit for rounding an n-bit number to an m-bit number of claim 8.

13. Computer readable code configured to cause the method of any of claims 1 to 7 to be performed when the code is run on a computer system.

# EP 4 418 103 B1

**Patentansprüche**

1. Computerimplementiertes Verfahren zum Runden einer nicht vorzeichenbehafteten normalisierten n-Bit-Zahl auf eine m-Bit-Zahl, wobei n > m > 0 ist, das Verfahren umfassend:

   Empfangen der n-Bit-Zahl in einem binären Format;
   **gekennzeichnet durch**
   Bestimmen eines Korrekturwerts mit einer Bitlänge von n Bits, wobei das Bestimmen des Korrekturwerts das Rechtsverschieben der n-Bit-Zahl um m Bits umfasst;
   Bestimmen eines Vorabkürzungswerts mit einer Bitlänge von n Bits basierend auf der n-Bit-Zahl, dem Korrekturwert, einem Wert für das höchstwertige Bit (MSB) der n-Bit-Zahl und einem Rundungswert mit einer '**1**' an der n-m-ten Bit-Position und einer '**0**' an allen anderen Bits, wobei der Vorabkürzungswert bestimmt wird durch Ausführen einer oder mehrerer Additions- und/oder Subtraktionsoperationen an der n-Bit-Zahl, dem Rundungswert, dem Korrekturwert und dem Wert für das MSB der n-Bit-Zahl; und
   Erhalten der gerundeten m-Bit-Zahl durch Verkürzen der n-m niedrigstwertigen Bits (LSB) des Vorabkürzungswerts.

2. Computerimplementiertes Verfahren nach einem der vorhergehenden Ansprüche, wobei der Rundungswert durch Verschieben eines Werts von '**1**' nach links um n-m-1 Bits bestimmt wird, wodurch ein 1 Bit an der n-m-ten Bitposition positioniert wird.

3. Computerimplementiertes Verfahren nach einem der vorhergehenden Ansprüche, wobei der Wert für das MSB der n-Bit-Zahl durch Verschieben der Zahl nach rechts um n-1 Bits identifiziert wird.

4. Computerimplementiertes Verfahren nach einem der vorhergehenden Ansprüche, wobei das Bestimmen eines Vorabkürzungswerts Folgendes umfasst:

   Subtrahieren des Korrekturwerts von der n-Bit-Zahl;
   Subtrahieren einer invertierten Version des Werts für das MSB von dem Rundungswert; und
   Addieren der Ausgabe aus den zwei Subtraktionen, um den Vorabkürzungswert zu erzeugen.

5. Computerimplementiertes Verfahren nach Anspruch 4, wobei die invertierte Version des Werts für das MSB durch Ausführen einer NOT-Operation des LSB des Werts für das MSB erhalten wird.

6. Computerimplementiertes Verfahren nach einem der Ansprüche 1 bis 3, wobei das Bestimmen eines Vorabkürzungswerts Folgendes umfasst:

   Invertieren des Korrekturwerts; und
   Addieren des invertierten Korrekturwerts, des Rundungswerts und des Werts für das MSB der n-Bit-Zahl zu der n-Bit-Zahl, um den Vorabkürzungswert zu erzeugen.

7. Computerimplementiertes Verfahren nach Anspruch 6, wobei das Invertieren des Korrekturwerts das Durchführen einer NOT-Operation an den Bits des Korrekturwerts umfasst.

8. Binäre Logikschaltung zum Runden einer nicht vorzeichenbehafteten normalisierten n-Bit-Zahl auf eine m-Bit-Zahl, wobei n > m > 0 ist, die binäre Logikschaltung umfassend:

   einen Eingang, der so konfiguriert ist, dass er die n-Bit-Zahl empfängt;
   ferner **dadurch gekennzeichnet, dass** es Folgendes umfasst:

   Korrekturwertlogik, die so konfiguriert ist, dass sie einen Korrekturwert mit einer Bitlänge von n Bits erzeugt, wobei die Logik einen Schieber zum Rechtsverschieben der n-Bit-Zahl um m Bits umfasst;
   MSB-Wertlogik, die so konfiguriert ist, dass sie einen Wert für das höchstwertige Bit (MSB) der n-Bit-Zahl bestimmt;
   Vorabkürzungswertlogik, die so konfiguriert ist, dass sie einen Vorabkürzungswert mit einer Bitlänge von n Bits basierend auf der n-Bit-Zahl, dem Korrekturwert, dem Wert für das MSB der empfangenen Zahl und einen Rundungswert mit einer '1' an der n-m-ten Bitposition und einer '0' an allen anderen Bits bestimmt, wobei die Vorabkürzungswertlogik eine oder mehrere Additions- und/oder Subtraktionsoperationen an der

17

n-Bit-Zahl, dem Rundungswert, dem Korrekturwert und dem Wert für das MSB der n-Bit-Zahl durchführt, um den Vorabkürzungswert zu bestimmen;

Kürzungslogik, die so konfiguriert ist, dass sie den Vorabkürzungswert durch Verwerfen der n-m LSB-Bits verkürzt, um eine gerundete m-Bit-Zahl zu erhalten; und

eine Ausgabe, die so konfiguriert ist, dass sie die gerundete m-Bit-Zahl ausgibt.

9. Binäre Logikschaltung nach Anspruch 8, ferner umfassend eine Rundungswertlogik, die so konfiguriert ist, dass sie den Rundungswert durch Verschieben des Werts von **'1'** nach links um n-m-1 Bits bestimmt, wodurch ein '1'-Bit an der n-m-ten Bitposition positioniert wird.

10. Binäre Logikschaltung nach einem der Ansprüche 8 oder 9, wobei die MSB-Wertlogik den Wert für das MSB der Zahl durch Verschieben der Zahl um n-1 Bits nach rechts identifiziert.

11. Binäre Logikschaltung nach einem der Ansprüche 8 bis 10, wobei die binäre Logikschaltung in Hardware auf einer integrierten Schaltung verkörpert ist.

12. Bildkompressionsschaltung umfassend die binäre Logikschaltung zum Runden einer n-Bit-Zahl auf eine m-Bit-Zahl nach Anspruch 8.

13. Computerlesbarer Code, der so konfiguriert ist, dass er das Durchführen des Verfahrens nach einem der Ansprüche 1 bis 7 veranlasst, wenn der Code auf einem Computersystem ausgeführt wird.


**Revendications**

1. Procédé mis en œuvre par ordinateur pour arrondir un nombre à n bits normalisés non signés à un nombre à m bits, où n > m > 0, le procédé comprenant :

   la réception du nombre à n bits dans un format binaire ;
   **caractérisé par**
   la détermination d'une valeur de correction ayant une longueur de bits de n bits, dans lequel la détermination de la valeur de correction comprend le décalage à droite du nombre à n bits de m bits ;
   la détermination d'une valeur de prétroncature ayant une longueur de bits de n bits sur la base du nombre à n bits, la valeur de correction, une valeur pour le bit le plus significatif (MSB) du nombre à n bits, et une valeur d'arrondi ayant un « 1 » à la position de n-mième bit et un « 0 » à tous les autres bits, dans lequel la valeur de prétroncature est déterminée en réalisant une ou plusieurs opérations d'addition et/ou de soustraction sur le nombre à n bits, la valeur d'arrondi, la valeur de correction et la valeur pour le MSB du nombre à n bits ; et
   l'obtention du nombre à m bits arrondi par troncature des n-m bits les moins significatifs (LSB) de la valeur de prétroncature.

2. Procédé mis en œuvre par ordinateur selon l'une quelconque des revendications précédentes, dans lequel la valeur d'arrondi est déterminée en décalant une valeur de « 1 » vers la gauche de n-m-1 bits, positionnant ainsi un bit de 1 à la position de n-mième bit.

3. Procédé mis en œuvre par ordinateur selon l'une quelconque des revendications précédentes, dans lequel la valeur pour le MSB du nombre à n bits est identifiée en décalant le nombre vers la droite de n-1 bits.

4. Procédé mis en œuvre par ordinateur selon l'une quelconque des revendications précédentes, dans lequel la détermination d'une valeur de prétroncature comprend :

   la soustraction de la valeur de correction du nombre à n bits ;
   la soustraction d'une version inversée de la valeur pour le MSB de la valeur d'arrondi ; et
   l'addition du résultat des deux soustractions pour générer la valeur de prétroncature.

5. Procédé mis en œuvre par ordinateur selon la revendication 4, dans lequel la version inversée de la valeur pour le MSB est obtenue en réalisant une opération NON sur le LSB de la valeur pour le MSB.

6. Procédé mis en œuvre par ordinateur selon l'une quelconque des revendications 1 à 3, dans lequel la détermination d'une valeur de prétroncature comprend :

l'inversion de la valeur de correction ; et
l'addition de la valeur de correction inversée, de la valeur d'arrondi et de la valeur pour le MSB du nombre à n bits au nombre à n bits pour générer la valeur de prétroncature.

7. Procédé mis en œuvre par ordinateur selon la revendication 6, dans lequel l'inversion de la valeur de correction comprend la réalisation d'une opération NON sur les bits de la valeur de correction.

8. Circuit logique binaire pour arrondir un nombre à n bits normalisé non signé à un nombre à m bits, où $n > m > 0$, le circuit logique binaire comprenant :

une entrée configurée pour recevoir le nombre à n bits ;
**caractérisé en ce qu'**il comprend en outre :

une logique de valeur de correction configurée pour générer une valeur de correction ayant une longueur de bits de n bits, la logique comprenant un dispositif de décalage pour décaler le nombre à n bits à droite de m bits ;
une logique de valeur MSB configurée pour déterminer une valeur pour le bit le plus significatif (MSB) du nombre à n bits ;
une logique de valeur de prétroncature configurée pour déterminer une valeur de prétroncature ayant une longueur de bits de n bits sur la base du nombre à n bits, la valeur de correction, la valeur pour le MSB du nombre reçu, et une valeur d'arrondi ayant un « 1 » à la position de n-m$^{ième}$ bit et un « 0 » à tous les autres bits, dans lequel la logique de valeur de prétroncature réalise une ou plusieurs opérations d'addition et/ou de soustraction sur le nombre à n bits, la valeur d'arrondi, la valeur de correction et la valeur pour le MSB du nombre à n bits pour déterminer la valeur de prétroncature ;
une logique de troncature configurée pour tronquer la valeur de pré-troncature en rejetant les n-m bits LSB pour obtenir un nombre à m bits arrondi ; et
un résultat configuré pour fournir en sortie le nombre à m bits arrondi.

9. Circuit logique binaire selon la revendication 8, comprenant en outre une logique de valeur d'arrondi configurée pour déterminer la valeur d'arrondi en décalant la valeur de « 1 » vers la gauche de n-m-1 bits, positionnant ainsi un bit « 1 » à la position de n-mième bit.

10. Circuit logique binaire selon l'une quelconque des revendications 8 ou 9, dans lequel la logique de valeur MSB identifie la valeur pour le MSB du nombre en décalant le nombre vers la droite de n-1 bits.

11. Circuit logique binaire selon l'une quelconque des revendications 8 à 10, dans lequel le circuit logique binaire est incorporé en matériel sur un circuit intégré.

12. Circuit de compression d'image comprenant le circuit logique binaire pour arrondir un nombre à n bits à un nombre à m bits selon la revendication 8.

13. Code lisible par ordinateur configuré pour amener le procédé de l'une quelconque des revendications 1 à 7 à être réalisé lorsque le code est exécuté sur un système d'ordinateur.

FIG. 1

FIG. 2

FIG. 3

402

Receive an n bit number (input value),
the value of n and m, where n is greater
than or equal to m

404

No          If n>m          Yes

406

Return the n bit number

408

Compute a correction value and the
MSB value of the n bit number

410

Provide the rounding value

412

Compute a pre-truncation value at
least based on the correction value,
the MSB value and the rounding
value

**FIG. 4**

FIG. 5

EP 4 418 103 B1

FIG. 6

25

←————————————n=8 bits————————————→

←————m=5 bits————→

| 0 | 0 | 1 | 0 | 1 | 1 | 1 | 0 |

Input number

●—Shift right by m=5 bits—➤

| 0 | 0 | 0 | 0 | 0 | 0 | 0 | 1 |

Correction value

3 MSB bits of input number

| 1 | 1 | 1 | 1 | 1 | 1 | 1 | 0 |

Inverted Correction value

●————Shift right by n-1=7 bits————➤

| 0 | 0 | 0 | 0 | 0 | 0 | 0 | 0 |

MSB_VAL

MSB bit

| 0 | 0 | 0 | 0 | 0 | 0 | 0 | 1 |

NOT_MSB

Shift left by n-m-1=2 bits

←————●

| 0 | 0 | 0 | 0 | 0 | 1 | 0 | 0 |

Rounding value

**FIG. 7A**

| 0 | 0 | 1 | 0 | 1 | 1 | 1 | 0 | Input number |

510a

| 0 | 0 | 0 | 0 | 0 | 0 | 0 | 1 | Correction value |

| 0 | 0 | 1 | 0 | 1 | 1 | 0 | 1 | <u>702</u> Output of subtractor 510a |

| 0 | 0 | 0 | 0 | 0 | 1 | 0 | 0 | Rounding value |

510b

| 0 | 0 | 0 | 0 | 0 | 0 | 0 | 1 | NOT_MSB |

| 0 | 0 | 0 | 0 | 0 | 0 | 1 | 1 | <u>704</u> Output of subtractor 510b |

| 0 | 0 | 0 | 0 | 0 | 0 | 1 | 1 | <u>704</u> Output of subtractor 510b |

510c

| 0 | 0 | 1 | 0 | 1 | 1 | 0 | 1 | <u>702</u> Output of subtractor 510a |

| 0 | 0 | 1 | 1 | 0 | 0 | 0 | 0 | <u>706</u> Output of adder 510c (Pretruncation value) |

| 0 | 0 | 1 | 1 | 0 | Rounded output |

| 0 | 0 | 1 | 1 | 0 | 0 | 0 | 1 | Bit replicated n bit number |

**FIG. 7B**

| | | | | | | | | |
|---|---|---|---|---|---|---|---|---|
| | 0 | 0 | 1 | 0 | 1 | 1 | 1 | 0 | Input number |

610a (+)

| | | | | | | | | |
|---|---|---|---|---|---|---|---|---|
| | 1 | 1 | 1 | 1 | 1 | 1 | 1 | 0 | Correction value |

| | | | | | | | | |
|---|---|---|---|---|---|---|---|---|
| 1 | 0 | 0 | 1 | 0 | 1 | 1 | 0 | 0 | 708 Output of adder 610a |

| | | | | | | | | |
|---|---|---|---|---|---|---|---|---|
| | 0 | 0 | 0 | 0 | 0 | 1 | 0 | 0 | Rounding value |

610b (+)

| | | | | | | | | |
|---|---|---|---|---|---|---|---|---|
| | 0 | 0 | 0 | 0 | 0 | 0 | 0 | 0 | MSB_VAL |

| | | | | | | | | |
|---|---|---|---|---|---|---|---|---|
| | 0 | 0 | 0 | 0 | 0 | 1 | 0 | 0 | 710 Output of adder 610b |

| | | | | | | | | |
|---|---|---|---|---|---|---|---|---|
| | 0 | 0 | 0 | 0 | 0 | 0 | 1 | 1 | 710 Output of subtractor 610b |

610c (+)

| | | | | | | | | |
|---|---|---|---|---|---|---|---|---|
| 1 | 0 | 0 | 1 | 0 | 1 | 1 | 0 | 1 | 708 Output of subtractor 610a |

| | | | | | | | | |
|---|---|---|---|---|---|---|---|---|
| 1 | 0 | 0 | 1 | 1 | 0 | 0 | 0 | 0 | Output of adder 610c |

| | | | | | | | | |
|---|---|---|---|---|---|---|---|---|
| 1 | 0 | 0 | 1 | 1 | 0 | 0 | 0 | 0 | Output of adder 610c |

AND

| | | | | | | | | |
|---|---|---|---|---|---|---|---|---|
| 0 | 1 | 1 | 1 | 1 | 1 | 1 | 1 | 1 | n bit mask |

| | | | | | | | | |
|---|---|---|---|---|---|---|---|---|
| | 0 | 0 | 1 | 1 | 0 | 0 | 0 | 0 | 712 Pre-truncation value |

| | | | | | |
|---|---|---|---|---|---|
| 0 | 0 | 1 | 1 | 0 | Rounded output |

| | | | | | | | | |
|---|---|---|---|---|---|---|---|---|
| 0 | 0 | 1 | 1 | 0 | 0 | 0 | 1 | Bit replicated n bit number |

**FIG. 7C**

**FIG. 8**

904          902          906

IC definition
dataset → | Layout processing | Circuit layout definition | Integrated circuit generation | → Integrated circuit

**FIG. 9**

**EP 4 418 103 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 2302254 A
- US 2014280405 A1
- US 2022334799 A1
- US 5696710 A